Europäisches Patentamt

European Patent Office

Office européen des brevets

(19)

(11) Publication number: **0 294 986 B1**

# EUROPEAN PATENT SPECIFICATION

(12)

(45) Date of publication of patent specification: **29.07.92**   (51) Int. Cl.⁵: **H03K 3/354**

(21) Application number: **88304948.8**

(22) Date of filing: **31.05.88**

(54) Multivibrator circuit employing field effect devices.

(30) Priority: **09.06.87 JP 144382/87**
    **09.06.87 JP 144383/87**
    **30.06.87 JP 164302/87**

(43) Date of publication of application:
**14.12.88 Bulletin 88/50**

(45) Publication of the grant of the patent:
**29.07.92 Bulletin 92/31**

(84) Designated Contracting States:
**DE FR GB**

(56) References cited:
**EP-A- 0 020 868**
**US-A- 3 855 551**
**US-A- 4 468 636**

**PATENT ABSTRACTS OF JAPAN, vol. 9, no. 288 (E-358)[2011], 15th November 1985; & JP - A - 60 128 709 (HITACHI SEISAKUSHO LTD.) 09-07-1985**

**A.B. GREBENE: "Bipolar and MOS analog integrated circuit design", pages 571-581, John Wiley & Sons, 1984, New York; US**

(73) Proprietor: **MITSUBISHI DENKI KABUSHIKI KAISHA**
**2-3, Marunouchi 2-chome Chiyoda-ku Tokyo 100(JP)**

(72) Inventor: **Tanino, Noriyuki Mitsubishi Denki K.K.LSI**
**Kenkyusho 1 Mizuhara 4-chome**
**Itami-shi Hyogo-ken(JP)**

(74) Representative: **Beresford, Keith Denis Lewis et al**
**BERESFORD & Co. 2-5 Warwick Court High Holborn**
**London WC1R 5DJ(GB)**

**Description**

BACKGROUND OF THE INVENTION

Field of the Invention

The present invention relates to a multivibrator circuit and, more particularly, to a multivibrator circuit in which the drift of oscillation frequency with changes in ambient temperature is compensated.

Description of the Prior Art

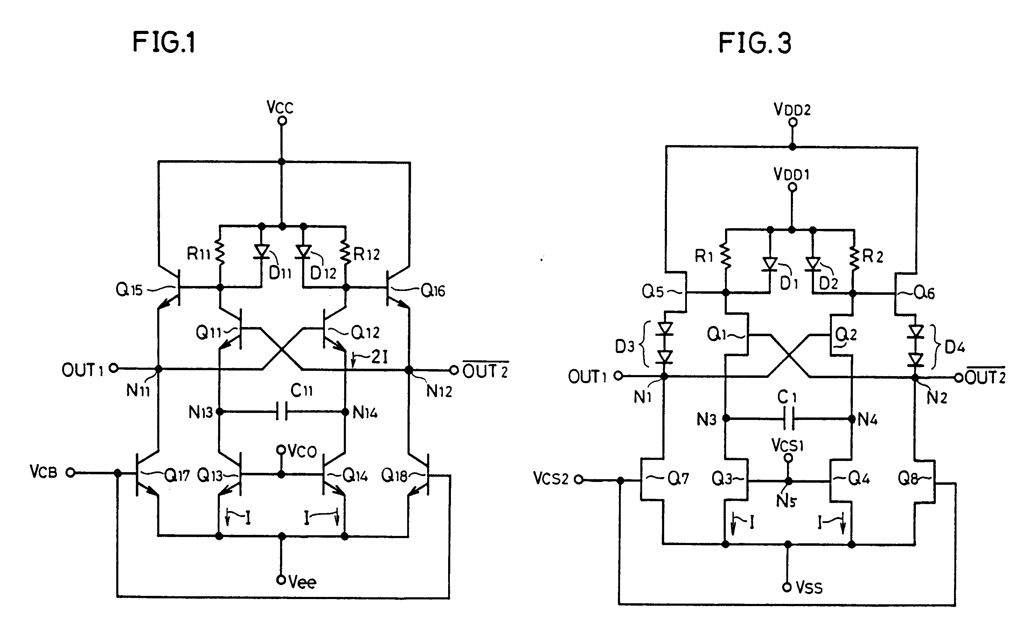

Fig. 1 is a schematic diagram showing an emitter-coupled multivibrator circuit employing conventional silicon npn-type bipolar transistors. A similar circuit is described in "Bipolar and MOS Analog Integrated circuit Design" by A.B. Grebene, published by Micro-Linear Corporation in 1984.

Referring to Fig. 1, the multivibrator circuit comprises four series connections between a power supply $V_{cc}$ and the ground $V_{ee}$. The first series connection comprises a first parallel connection of a resistor $R_{11}$ and a diode $D_{11}$, and npn type bipolar transistors $Q_{11}$ and $Q_{13}$. The emitter of the transistor $Q_{11}$ and the collector of the transistor $Q_{13}$ are connected together to constitute a node $N_{13}$. The second series connection comprises npn type bipolar transistors $Q_{15}$ and $Q_{17}$. The emitter of the transistor $Q_{15}$ and the collector of the transistor $Q_{17}$ are connected together to constitute a node $N_{11}$. The node $N_{11}$ is connected to a first output $OUT_1$. The base of the transistor $Q_{15}$ is connected to a connection point between the collector of the transistor $Q_{11}$ and the first parallel connection. The third series connection comprises a second parallel connection of a resistor $R_{12}$ and a diode $D_{12}$, and npn type bipolar transistors $Q_{12}$ and $Q_{14}$. The emitter of the transistor $Q_{12}$ and the collector of the transistor $Q_{14}$ are connected together to constitute a node $N_{14}$. The base of the transistor $Q_{12}$ is connected to the first output $OUT_1$. A capacitor $C_{11}$ is connected between the node $N_{13}$ and the node $N_{14}$. The bases of the transistors $Q_{13}$ and $Q_{14}$ are connected together and a connection point therebetween is connected to a first constant voltage supply $V_{co}$. The fourth series connection comprises npn type bipolar transistors $Q_{16}$ and $Q_{18}$. The emitter of the transistor $Q_{16}$ and the collector of the transistor $Q_{18}$ are connected together to constitute a node $N_{12}$. The node $N_{12}$ is connected to a second output $\overline{OUT_2}$. The base of the transistor $Q_{16}$ is connected to a connection point between the collector of the transistor $Q_{12}$ and the second parallel connection. The base of the transistor $Q_{11}$ is connected to the second output $\overline{OUT_2}$. The bases of the transistors $Q_{17}$ and $Q_{18}$ are connected together and the connection point therebetween is connected to a second constant supply voltage $V_{CB}$.

Next, description is made of operation of the circuit.

Either one of the transistors $Q_{11}$ and $Q_{12}$ constituting an emitter-coupled switch is always on and the other is off.

First, assuming that the transistor $Q_{11}$ is off and the transistor $Q_{12}$ is on, a current I flows from the node $N_{14}$ to the node $N_{13}$ through the capacitor $C_{11}$, because the current I is always flowing through the transistors $Q_{13}$ and $Q_{14}$ serving as constant current load in response to a voltage applied to a first control input. Therefore, a current of 2I flows through the transistor $Q_{12}$. A collector voltage of the transistor $Q_{12}$ is decreased by a voltage of $2IR_2$ by a resistor $R_{12}$ (a resistance value is also represented by $R_{12}$). Since a barrier voltage $\phi_B$ of the diode $D_{12}$ and a value ($R_{12}$) of the resistor $R_{12}$ are selected so as to satisfy the relation of $2IR_{12} \geqq \phi_B$, the collector voltage of the transistor $Q_{12}$ is clamped at $V_{cc} - \phi_B$. As a result, an emitter voltage $V (N_{12})$ of the transistor $Q_{16}$ becomes $V_{cc} - 2\phi_B$ which is lower than a base voltage $V_{cc} - \phi_B$ by the voltage $\phi_B$.

On the other hand, when an emitter voltage $V (N_{13})$ of the transistor $Q_{11}$ is reduced by the current I flowing through the capacitor $C_{11}$ and becomes $V_{cc} - 3\phi_B$ which is lower than the base voltage $V_{cc} - 2\phi_B$ of the transistor $Q_{11}$ by the voltage $\phi_B$, the transistor $Q_{11}$ is turned on. As a result, a base voltage of the transistor $Q_{15}$ is reduced from $V_{cc}$ to $V_{cc} - \phi_B$ and an emitter voltage $V (N_{11})$ of the transistor $Q_{15}$ is reduced from $V_{cc} - \phi_B$ to $V_{cc} - 2\phi_B$. Since an emitter voltage $V (N_{14})$ of the transistor $Q_{12}$ changes with a delay of a sufficiently large time constant by the capacitor $C_{11}$ as compared with switching operation of the transistors $Q_{11}$ and $Q_{12}$, it is equal to an emitter voltage of $V_{cc} - 2\phi_B$ when the transistor $Q_{12}$ is on. Therefore, the transistor $Q_{12}$ is turned off.

After the transistor $Q_{12}$ is turned off, the base voltage of the transistor $Q_{11}$ is raised by a voltage $\phi_B$ and the voltages $V (N_{13})$ and $V (N_{14})$ across the capacitor $C_{11}$ are raised from $V_{cc} - 3\phi_B$ to $V_{cc} - 2\phi_B$ and from $V_{cc} - 2\phi_B$ to $V_{cc} - \phi_B$, respectively. As a result, the states of the transistors $Q_{11}$ and $Q_{12}$ initially set have been changed with each other.

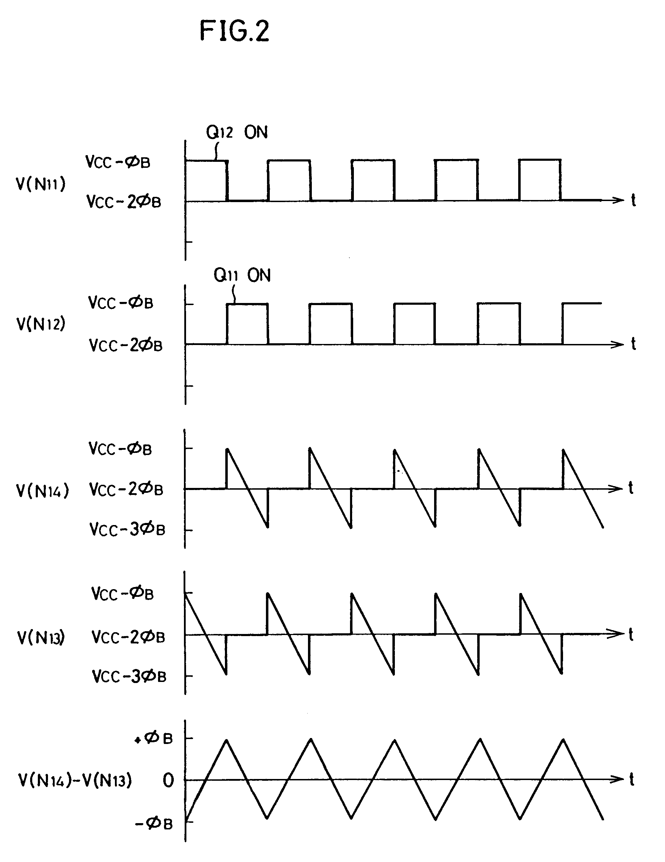

Fig. 2 is a timing chart showing changes of the first and second output voltages $V(N_{11})$ and $V(N_{12})$ of the emitter-coupled multivibrator circuit in Fig. 1 and the voltages $V(N_{14})$ and $V(N_{13})$ of the nodes $N_{14}$ and $N_{13}$ as well as a change of the voltage difference $V(N_{14}) - V(N_{13})$ across the capacitor $C_{11}$.

An oscillation frequency $f_0$ of the multivibrator circuit shown in Fig. 1 is represented by the following equation:

$$f_0 = I/4\phi_B$$

where C is a capacitance value of the capacitor $C_{11}$, I is a current flowing through the transistors $Q_{13}$ and $Q_{14}$ for constant current loads of the emitter-coupled switch portion, and reference $2\phi_B$ is a maximum amplitude voltage applied across the capacitor $C_{11}$. Since the current I can be controlled by a voltage $V_{co}$ applied to the bases of the transistors $Q_{13}$ and $Q_{14}$, the emitter-coupled multivibrator circuit shown in Fig. 1 is a voltage-controlled type oscillation circuit.

Since the conventional emitter-coupled multivibrator circuit shown in Fig. 1 employs a silicon bipolar transistor, power consumption is high. As a consequence there is a tendency for the fluctuations in operating temperature to be large and, as a result and in the absence of compensation, the oscillating frequency can drift or become unstable.

Techniques for improving temperature stability in circuits such as that shown in Fig. 1 are also described in the abovementioned article by A B Grebene. In one of these techniques the oscillating current is made proportional to the diodic voltage drop imposed on the circuit. In any of these techniques the circuit configuration is modified to eliminate voltage drop dependency in the frequency expression describing the behaviour of the circuit. In each case the details of implementation are complex.

## DISCLOSURE OF THE INVENTION

The present invention is intended to provide a multivibrator circuit in which provision is made for compensating frequency drift or instability due to changes of temperature. A simple alternative is provided to the compensation techniques just mentioned.

In accordance with the present invention there is provided a multivibrator circuit comprising: first and second alternately operable transistors; first and second current sources connected to each first and second transistor respectively; first and second voltage drop clamp circuit means, including respective first and second diode means, connected to each first and second transistor respectively; and timing capacitance means connected between a junction of said first transistor with said first current source and a junction of said second transistor with said second current source; wherein said circuit is so configured to produce an oscillating signal the frequency $f_0$ of which is given by the expression:

$$f_0 = I/4\phi_B; \text{ where}$$

I is the current supplied from each current source, C is the capacitance of said timing capacitance means, and $2\phi_B$ the range of voltage change across said capacitance means, $\phi_B$ being the diodic drop voltage of each of said first and second diode means; which circuit is characterized in that:

each first and second current source comprises a field effect transistor and has a third diode means connected between its gate electrode and its source electrode to effect a reduction in the temperature coefficient of the oscillation frequency $f_0$.

As just set forth, the problem of compensating temperature variation of the multivibrator oscillation frequency is solved by providing current sources of field-effect transistor (FET) construction and by connecting the gates of these transistors to their sources by means of an appropriately selected diodic shunt. The construction then is elegantly simple and is easy to implement.

Since current sourcing is provided by field-effect transistors, power consumption is reduced. Where all transistors are of the field-effect type, as in the preferred embodiment described hereinafter, the power consumption is reduced considerably. At the same time it is possible to achieve stable operation at particularly high frequencies.

## BRIEF DESCRIPTION OF THE DRAWINGS

In the accompanying drawings:
Fig. 1 is a schematic diagram showing a multivibrator circuit employing conventional npn type bipolar transistors;

3

Fig. 2 is a timing chart for explaining operation of the multivibrator circuit of Fig. 1;

Fig. 3 is a schematic diagram showing a multivibrator circuit similar to that of Fig. 1 but employing field-effect transistors in place of conventional bipolar transistors;

Fig. 4 is a graph showing the static characteristics of drain voltage and drain current of a field-effect transistor such as is used in the multivibrator circuit of Fig. 3;

Fig. 5 is a timing chart for explaining operation of the multivibrator circuit shown in Fig. 3;

Fig. 6 is a schematic diagram showing a multivibrator circuit similar to that of Fig. 3 but in which temperature compensation is provided in accordance with the present invention;

Fig. 7 is cancelled;

Fig. 8 is a block diagram of a high-frequency superposing circuit for reducing a return light noise of a laser diode for showing an example of application of the present invention;

Fig. 9 is a schematic diagram showing an example of an amplification circuit and a laser diode drive circuit shown in the block diagram of Fig. 8.

DESCRIPTION OF A PREFERRED EMBODIMENT

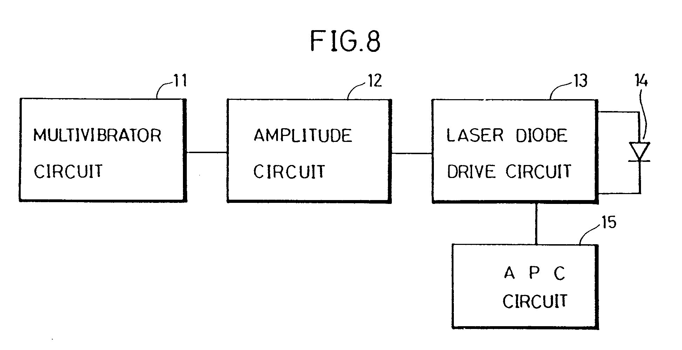

As background to the description of Fig. 6 of the drawings (which shows the preferred embodiment of the invention) here follows a brief discussion of a field-effect transistor implementation of the Fig. 1 multivibrator circuit.

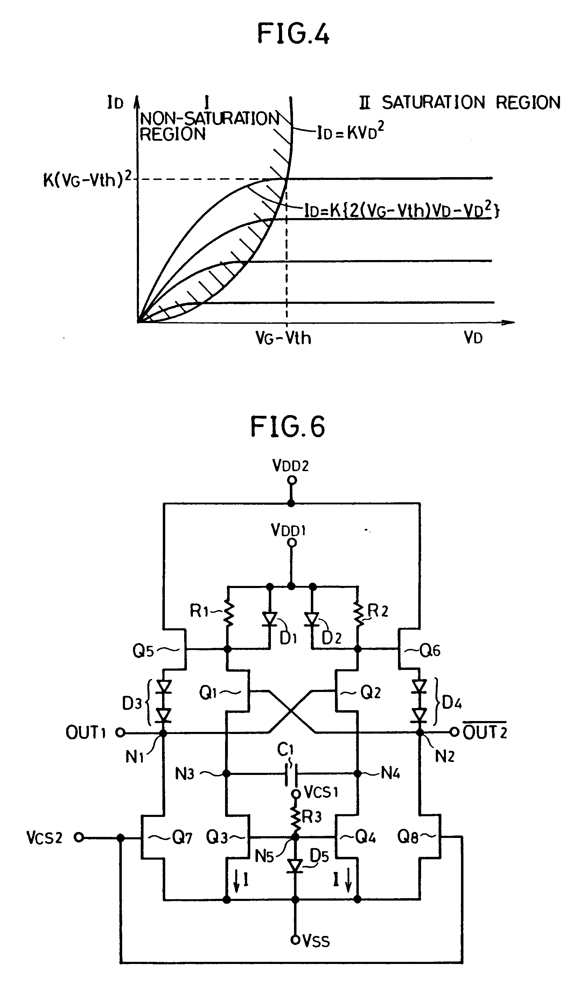

Referring to Fig. 3, the multivibrator circuit employing field-effect transistors comprises four series connections. The first and third series connections are provided between a first power supply $V_{DD1}$ and the ground $V_{SS}$. The second and fourth connections are provided between a second power supply $V_{DD2}$ and the ground $V_{SS}$. The first series connection comprises a first clamp circuit in which a resistor $R_1$ and a diode $D_1$ are connected in parallel, an n type field effect transistor $Q_1$ constituting a source-coupled switch and an n type field effect transistor $Q_3$ as a current source. The transistor $Q_1$ has its drain connected to the first clamp circuit and its source connected to the drain of the transistor $Q_3$ together to constitute a node $N_3$. The transistor $Q_3$ has its source connected to the ground $V_{SS}$. The second series connection comprises an n type field effect transistor $Q_5$ constituting a source follower, two diodes $D_3$ for shifting level, and an n type field effect transistor $Q_7$. The transistor $Q_5$ has its drain connected to the second power supply $V_{DD2}$ and the transistor $Q_5$ has its source connected to the anode of the diode $D_3$. The drain of the transistor $Q_7$ and the cathode of the diode $D_3$ are connected together to constitute a node $N_1$. The node $N_1$ is connected to a first output OUT $_1$. The transistor $Q_5$ has its gate connected to a connection point between the drain of the transistor $Q_1$ and the first clamp circuit. The transistor $Q_5$ and the diode $D_3$ constitute a first level shift circuit. The third series connection comprises a second clamp circuit in which a resistor $R_2$ and a diode $D_2$ are connected in parallel, an n type field effect transistor $Q_2$ constituting the source-coupled switch and an n type field effect transistor $Q_4$ as a current source. The transistor $Q_2$ has its drain connected to the second clamp circuit and the transistor $Q_2$ has its source connected together to the drain of the transistor $Q_4$ to constitute a node $N_4$ and its gate connected to the first output $OUT_1$. The transistor $Q_4$ has its source connected to the ground $V_{SS}$. A capacitor $C_1$ is connected between the node $N_3$ and the node $N_4$. Gates of the transistors $Q_3$ and $Q_4$ are connected together and a connection point thereof is connected to a first constant supply voltage $V_{CS1}$. The fourth series connection comprises an n type field effect transistor $Q_6$ constituting a source follower, two diodes $D_3$ for shifting level and an n type field effect transistor $Q_8$. The transistor $Q_6$ has its drain connected to the second power supply $V_{DD2}$ and the transistor $Q_6$ has its source connected to the anode of the diode $D_4$ The transistor $Q_6$ has its gate connected to a connection point of the drain of the transistor $Q_2$ and the second clamp circuit. The transistor $Q_6$ and the diode $D_6$ constitute the second level shift circuit. The transistor $Q_8$ has its drain connected together to be cathode of the diode $D_4$ to constitute a node $N_2$. The node $N_2$ is connected to a second output $\overline{OUT_2}$. The transistor $Q_1$ has its gate connected to the second output. The gates of the transistors $Q_7$ and $Q_8$ are connected together and a connection point thereof is connected to a second constant supply voltage $V_{CS2}$. The transistors $Q_3$ and $Q_4$ are constant power supply and control an amount of current flowing through the transistors $Q_3$ and $Q_4$, respectively, in response to the first constant supply voltage $V_{CS1}$. The transistors $Q_7$ and $Q_8$ are also constant power supplies and they control an amount of current flowing through the transistors $Q_7$ and $Q_8$, respectively, in response to a voltage applied to the second supply voltage $V_{CS2}$. Resistors $R_1$ and $R_2$ are load resistances of the transistors $Q_1$ and $Q_2$, respectively (the resistance values are $R_1$ and $R_2$, respectively). The diodes $D_1$ and $D_2$ limit a voltage drop due to the resistors $R_1$ and $R_2$, respectively. Both barrier voltages of the diodes $D_1$ and $D_2$ are represented by $\phi_B$.

In general, static characteristics of a field effect transistor are represented by the following equations:

$$I_D = K (V_G - V_{TH})^2 \qquad : \quad 0 < V_G - V_{TH} < V_D$$
$$I_D = K (2(V_G - V_{TH})V_D - V_D^2) \qquad : \quad V_D < V_G - V_{TH} \qquad \biggr\} (1)$$
$$I_D = 0 \qquad : \quad V_G - V_{TH} < 0$$

where $I_D$ is the drain current of the field effect transistor, $V_D$ is the drain voltage, $V_G$ is the gate voltage, $V_{TH}$ is a threshold voltage of the gate and K is a transconductance.

Fig. 4 is a graph showing static characteristics of the field effect device represented by the equation (1). Referring to Fig. 4, the field effect device performs constant current operation in a saturation region II shown in Fig. 4 regardless of the voltage applied to the drain.

Referring to the field effect transistor multivibrator circuit shown in Fig. 3, it is assumed that the transistors $Q_1$, $Q_2$, $Q_5$, and $Q_6$ operate in a saturation region. Assuming that gate voltages of the transistors $Q_1$, $Q_2$, $Q_5$ and $Q_6$ are threshold voltage $V_{TH}$ when a current $I_1$ flowing through the transistors $Q_3$, $Q_4$, $Q_7$ and $Q_8$, respectively serving as constant current loads is equal to the respective drain currents of the transistors $Q_1$, $Q_2$, $Q_5$ and $Q_6$, the respective source voltages of the transistors $Q_1$ and $Q_2$ are reduced by $V_{TH}$ as compared with the gate voltages when the transistors $Q_1$ and $Q_2$ are on. Respective source voltages of the transistors $Q_5$ and $Q_6$ are reduced by $V_{TH}$ as compared with the gate voltages.

Now, description is made of the operation of the transistors $Q_1$, $Q_2$, $Q_5$ and $Q_6$ in the saturation region.

Assuming that $Q_1$ is off and $Q_2$ is on, the respective source, gate and drain voltages of the transistors $Q_1$, $Q_2$, $Q_5$ and $Q_6$ are shown in table 1.

The field effect transistors operates in the saturation region on conditions that $V_G - V_{TH} < VD$ from the above described equation (1) is satisfied. Therefore, when the condition of

$$- \frac{\phi_B}{2} < V_{TH},$$

which solution of inequality has been found from the table 1, is satisfied, the transistors $Q_1$, $Q_2$, $Q_5$ and $Q_6$ operate in the saturation region.

Table 1

|  | source voltage | gate voltage | drain voltage |
|---|---|---|---|
| $Q_5$ (ON) | $V_{DD1} - V_{TH}$ | $V_{DD1}$ | $V_{DD2}$ |
| $Q_2$ (ON) | $V_{DD1} - 2\phi_B - 2V_{TH}$ | $V_{DD1} - 2\phi_B - V_{TH}$ | $V_{DD1} - \phi_B$ |
| $Q_6$ (ON) | $V_{DD1} - \phi_B - V_{TH}$ | $V_{DD1} - \phi_B$ | $V_{DD2}$ |
| $Q_1$ (OFF) | $V_{DD1} - 3\phi_B - 2V_{TH}$ <br> $V_{DD1} - \phi_B - 2V_{TH}$ | $V_{DD1} - 3\phi_B - V_{TH}$ | $V_{DD1}$ |

When

$$V_{TH} \leqq - \frac{\phi_B}{2},$$

the transistors $Q_1$, $Q_2$, $Q_5$ and $Q_6$ can operate in the saturation region by increasing the number of the diodes $D_3$ and $D_4$ in Fig. 3 to three or more.

On the other hand, in the multivibrator circuit shown in Fig. 3, assuming that the relation between $\phi_B$ and $V_{TH}$ is

$$-\phi_B \leq V_{TH} \leq - \frac{\phi_B}{2} \quad ,$$

the transistor $Q_2$ operates in a non-saturation region and the transistors $Q_1$, $Q_5$ and $Q_6$ operate in the saturation region, as it is obvious from the table 1. The voltage between the gate and source of the transistor $Q_2$ is reduced by more than $V_{TH}$ and a maximum voltage amplitude across the capacitor $C_1$ is less than $2\phi_B$ and dependent on the $V_{TH}$. Therefore, a high oscillation frequency is provided and it is more difficult to control the threshold voltage $V_{TH}$ than to control $\phi_B$. As a result, an oscillation frequency cannot be provided with good repeatability.

Description is now made of the operation of the multivibrator circuit in Fig. 3.

Either one of the transistors $Q_1$ and $Q_2$ constituting the source-coupled switch is on and the other is off.

First, assuming that the transistor $Q_1$ is off and the transistor $Q_2$ is on, a current I flows from the node $N_4$ to the node $N_3$ through the capacitor $C_1$ because the current I always flows through the respective transistors $Q_3$ and $Q_4$ serving as the current sources. Therefore, a current of 2I flows through the transistor $Q_2$. Although a drain voltage of the transistor $Q_2$ is reduced by $2IR_2$ by the resistor $R_2$, the drain voltage of the transistor $Q_2$ is clamped at $V_{DD1} - \phi_B$ if the value of the resistor $R_2$ is selected as a barrier voltage $\phi_B$ of the diode $D_2$ so as to satisfy the relation of $2IR_2 \geq \phi_B$. As a result, the source voltage of the transistor $Q_6$ becomes a voltage of $V_{DD1} - \phi_B - V_{TH}$ which is lower than a gate voltage of $V_{DD1} - \phi_B$ by the threshold voltage $V_{TH}$ of the transistor $Q_6$. At this time, the level of the gate voltage $V (N_2)$ of the transistor $Q_1$ is shifted to $V_{DD1} - 3\phi_B - V_{TH}$ by a level shift diode $D_4$.

On the other hand, the source voltage $V (N_3)$ of the transistor $Q_1$ is reduced by the current I flowing through the capacitor $C_1$. When the source voltage of the transistor $Q_1$ becomes a voltage of $VDD1 - 3\phi_B - 2V_{TH}$ which is lower than the gate voltage $V_{DD1} - 3\phi_B - V_{TH}$ of the transistor $Q_1$ by the threshold voltage $V_{TH}$ of the field effect transistor $Q_1$, the transistor $Q_1$ is turned on.

The gate voltage of the transistor $Q_5$ is reduced from $V_{DD1}$ to $V_{DD1} - \phi_B$ and the source voltage of the transistor $Q_5$ is reduced from $V_{DD1} - V_{TH}$ to $V_{DD1} - \phi_B - V_{TH}$. The gate voltage $V (N_1)$ of the transistor $Q_2$ is reduced from $V_{DD1} - 2\phi_B - V_{TH}$ to $V_{DD1} - 3\phi_B - V_{TH}$ by the level shift diode $D_3$. Since the source voltage $(N_4)$ of the transistor $Q_2$ is clamped at sufficiently large time constant by the capacitor $C_1$ as compared with the switching time of two transistors, it is equal to the source voltage $V_{DD1} - 2\phi_B - 2V_{TH}$ when the transistor $Q_2$ is on. Therefore, the transistor $Q_2$ is turned off.

When the transistor $Q_2$ is turned off, the gate voltage of the transistor $Q_1$ is raised by $\phi_B$ and the voltage $V (N_3)$ and $V (N_4)$ across the capacitor $C_1$ are raised from $V_{DD1} - 3\phi_B - 2V_{TH}$ to $V_{DD1} - 2\phi_B - 2V_{TH}$ and from $V_{DD1} - 2\phi_B - 2V_{TH}$ to $V_{DD1} - \phi_B - 2V_{TH}$, respectively.

As a result, the initial states in which the transistor $Q_1$ was off and the transistor $Q_2$ was on have changed with each other.

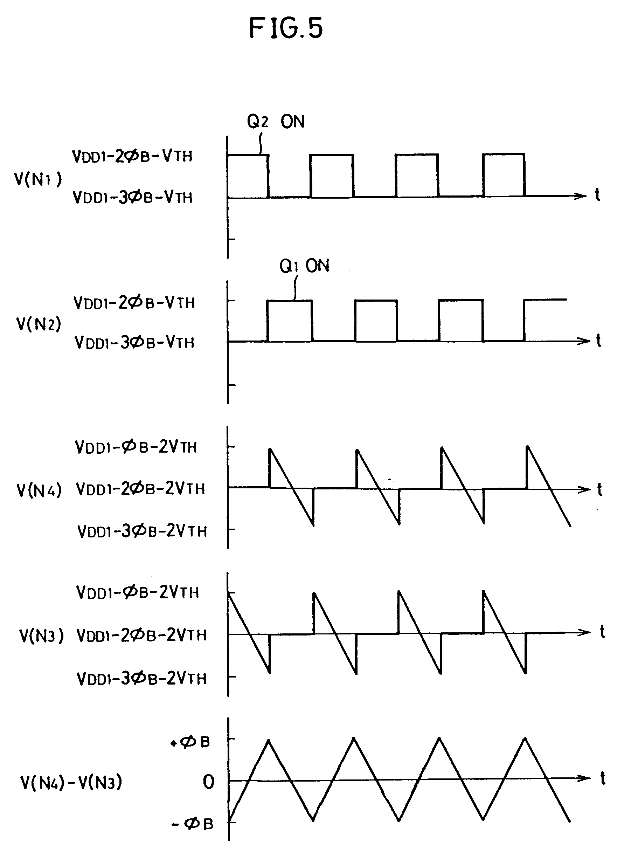

Fig. 5 is a timing chart showing changes in the voltages $V (N_1)$ and $V (N_2)$ of the first and second outputs, the potentials $V (N_4)$ and $V (N_3)$ across the capacitor $C_1$ and the voltage $V (N_4) - V (N_3)$ across the capacitor in the multivibrator circuit shown in Fig. 3.

An oscillation threshold frequency $f_0$ is determined by capacitance C of the capacitor $C_1$, a current value I flowing through the transistors $Q_3$ and $Q_4$ serving as power supply of the source-coupled switch portion and a maximum amplitude voltage $2\phi_B$ across the capacitor $C_1$ and the following equation is obtained:

$$f_0 = \frac{I}{4C\phi_B} \quad \cdots\cdots\cdots\cdots\cdots\cdots\cdots (2)$$

In the field effect transistor multivibrator circuit shown in Fig. 3, the oscillation frequency $f_0$ becomes higher because the oscillation frequency $f_0$ depends on the barrier voltage $\phi_B$ when the ambient temperature becomes higher, and the barrier voltage $\phi_B$ is reduced. The below described improvements will effectively prevent the ambient temperature from affecting the oscillation frequency $f_0$.

Fig. 6 is a schematic diagram showing another embodiment of a multivibrator circuit employing field effect transistors in accordance with the present invention.

The multivibrator circuit in Fig. 6 is additionally provided with a bias resistor $R_3$ connected between a

first constant supply voltage $V_{CS1}$ and a connection point of gates of the transistors $Q_3$ and $Q_4$, and a diode $D_5$ for temperature compensation connected between the connection point of the gates of the transistors $Q_3$ and $Q_4$ and the ground $V_{SS}$, as compared with the multivibrator circuit in Fig. 3. Although only one diode $D_5$ is shown in Fig. 6, a series connection of one or more diodes may also be applicable. Since other circuit portions of Fig. 6 are the same as those in Fig. 3, a description thereof is omitted.

Next, a description is made of operation of the multivibrator circuit of Fig. 6.

An oscillation frequency $f_0$ of the multivibrator circuit in Fig. 6 is also represented by the equation (2), which is the same as that of the circuit in Fig. 3.

When the ambient temperature is raised during operation, the barrier voltage $\phi_B$ of the diodes $D_1$ and $D_2$ is lowered. However, since the barrier voltage $\phi_B$ of the diode $D_5$ is also lowered at the same time, the gate voltages of the transistors $Q_3$ and $Q_4$ are lowered and the value I of the drain current flowing through the transistors $Q_3$ and $Q_4$ are also reduced. Therefore, since the rise of the oscillation frequency due to the drop of the barrier voltage $\phi_B$ can be offset by the decrease of the drain current value I, the oscillation frequency $f_0$ depends less on the temperature.

A temperature coefficient of the barrier voltage $\phi_B$ is generally represented by

$$\frac{d\phi_B}{\phi_B} \; / \; dT$$

and the drain current value I in the saturation region of a field effect transistor is represented by the following equation:

$$I = K (V_g - V_{TH})^2 \qquad (3)$$

where $V_g$ is a gate voltage, $V_{TH}$ is a threshold voltage and K is a coefficient.

Referring to Fig. 6, since the gate voltages $V_g$ of the transistors $Q_3$ and $Q_4$ are equal to the barrier voltage $\phi_B$, the equation (3) is also represented by the following equation:

$$I = K (\phi_B - V_{TH})^2 \qquad (4)$$

Assuming that both of coefficient K and the temperature coefficient of the threshold voltage $V_{TH}$ are significantly smaller than the temperature coefficient of the barrier voltage $\phi_B$, a temperature coefficient of the drain current I is represented by the following equation:

$$\frac{d I}{I} \; dT = \frac{2\phi_B}{\phi_B - V_{TH}} \; \frac{d\phi_B}{\phi_B} \; /dT \quad \cdots\cdots(5)$$

and a temperature coefficient of the oscillation frequency $f_0$ is represented by the following equation:

$$\frac{d f_0}{f_0} \; /dT = \frac{d I}{I} \; /dT - \frac{d\phi_B}{\phi_B} \; /dT$$

$$= \frac{\phi_B + V_{TH}}{\phi_B - V_{TH}} \cdot \frac{d\phi_B}{\phi_B} \; /dT \quad \cdots\cdots(6)$$

Therefore, if the threshold voltage $V_{TH}$ and the barrier voltage $\phi_B$ is selected so as to satisfy the relation of $V_{TH} = -\phi_B$, the temperature coefficient of the oscillation frequency $f_0$ can be reduced to the value which is a product of

$$\left| \quad \frac{1}{2} \quad \frac{d\phi_B}{\phi_B} \quad /dT \quad \right|$$

and the temperature coefficient of the oscillation frequency $f_0$ of the multivibrator circuit shown in Fig. 3.

It is understood that the number of diodes $D_1$, $D_2$, $D_3$ and $D_4$ of the multivibrator circuit in accordance with present invention shown in Fig. 6 is not limited to the number of diodes shown in the figure and series connection of one or more diodes can be applied.

A description is made of an example of application of the present invention in the following.

With recent developments in optical technologies, a demand for an oscillator having high operating speed and outputting an output signal with a high frequency in a stable manner has been increased.

In an optical disc, optical fiber communication, or optical fiber gyroscope, for example, a high frequency signal is applied to a laser diode using a high frequency superposed circuit in order to reduce light induced noise due to return light. A single mode laser of a refractive index waveguide type oscillates in a multi-mode so that noise due to return light can be effectively reduced. Some reports as indicated below are made with regard to this effect.

(1) Epworth, R E, "The Phenomenon of Modal Noise in Analog and Digital Optical Fiber Systems", Proc. 4th. Europ. Conf. Opt. Commun. (Genova, Italy), pp 492-501, Sept 1978.

(2) Vanderwall, J and Blackburn, J, "Suppression of Some Artifacts of Modal Noise in Fiber-Optic Systems", Opt. Lett Vol. 4, No 9, pp 295-296, Sept 1979.

(3) Sato, K and Asatani, K, "Speckle Noise Reduction in Fiber Optic Analog Video Transmission Using Semiconductor Laser Diode", IEEE Tr. Commun., Vol. COM-29, No 7, pp 1017- 1024, July 1981.

Fig. 8 is a block diagram of a high frequency superposed circuit for reducing the return light noise of a laser diode as an example of an application of the present invention.

Referring to Fig. 8, the high frequency superposed circuit comprises a high frequency multivibrator circuit 11, an amplitude circuit 12 amplifying a signal generated from the circuit 11 and a laser diode drive circuit 13. A laser diode 14 is connected to an output of the laser diode drive circuit 13 and an APC (Automatic Power control) circuit 15 for adjusting an optical output of the laser diode is also connected to the laser diode drive circuit 13.

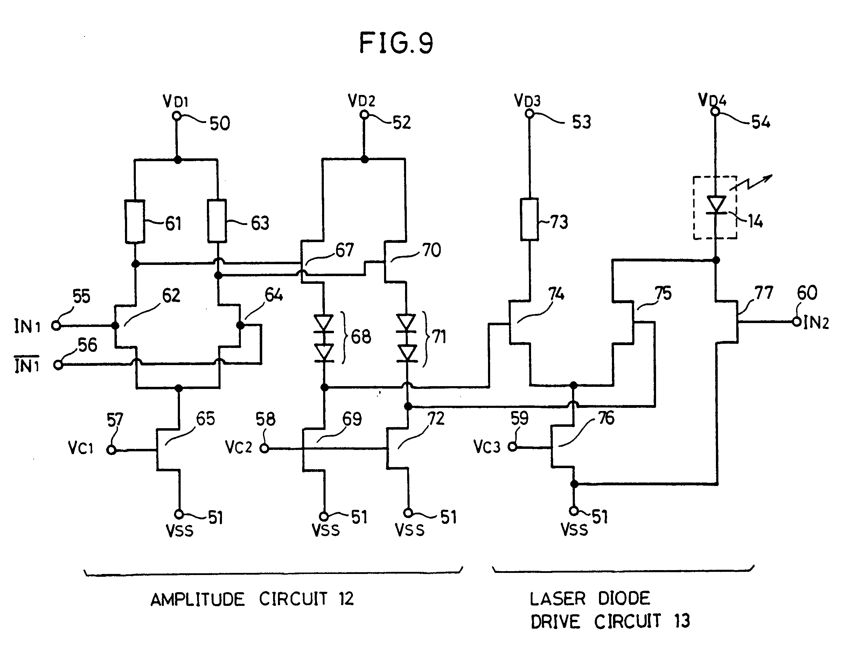

Fig. 9 is a schematic diagram showing one concrete example of the amplitude circuit 12 and the laser diode drive circuit 13 shown in Fig. 8.

Referring to Fig. 9, the amplitude circuit 12 comprises a circuit of a first stage connected between a power supply $V_{D1}$ and the ground $V_{SS}$ and a circuit of a second stage connected between a power supply $V_{D2}$ and the ground $V_{SS}$. The circuit of the first stage comprises an n channel field effect transistor 65 connected to a parallel connection which is formed between a series connection of a load 61 and an n channel field effect transistor 62 and a series connection of a load 63 and an n channel field effect transistor 64. The transistor 62 has its gate connected to an input $IN_1$ and the transistor 64 has its gate connected to an input $\overline{IN_1}$. The inputs $IN_1$ and $\overline{IN_1}$ are connected to receive signals of outputs $OUT_1$ and $\overline{OUT_1}$ of the multivibrator circuit of the present invention, respectively. The transistor 65 has its gate connected to a constant supply voltage $V_{C1}$. The circuit of the second stage comprises an n channel field effect transistor 67, two diodes 68 for level shifting and an n channel field effect transistor 69 connected in series between the power supply $V_{D2}$ and the ground $V_{SS}$. It further comprises an n channel field effect transistor 70, two diodes 71 for level shifting and an n channel field effect transistor 72 connected in series between the power supply $V_{D2}$ and the ground $V_{SS}$. The transistor 67 has its gate connected to the connection point between the load 61 and the transistor 62. The transistor 70 has its gate connected to the connection point between the load 63 and the transistor 64. The gate of the transistor 69 and the gate of the transistor 72 are connected together to a constant supply voltage $V_{C2}$.

In the laser diode drive circuit 13, a load 73 and an n channel field effect transistors 74 and 76 are connected in series between a power supply $V_{D3}$ and the ground $V_{SS}$. The transistor 74 has its gate connected to the connection point between the diodes 68 and the transistor 69. The transistor 76 has its gate connected to a constant supply voltage $V_{C3}$. A laser diode 14 and an n channel field effect transistor 77 are connected in series between a power supply $V_{D4}$ and the ground $V_{SS}$. The transistor 77 has its gate connected to an input $IN_2$. The input $IN_2$ is connected to receive an output signal of an APC circuit 15. An n channel field effect transistor 75 is connected between the connection point between the laser diode 14 and the transistor 77 and the connection point between the transistors 74 and 76. The transistor 75 has its gate connected to the connection point between the diode 71 and the transistor 72.

In operation of the high frequency superposed circuit shown in Fig. 9, the multivibrator circuit generates high frequency signal (several hundred MHz~ several GHz) necessary to reduce the light induced noise due to return light of the laser diode and applies the same to the inputs $IN_1$ and $\overline{IN_1}$ of the amplitude circuit 12. The amplitude circuit 12 receives the high frequency signal and the laser diode amplifies this signal to a signal level necessary for oscillation in a multimode. Then, the laser diode drive circuit 13 receives the amplified high frequency signal to apply it to the laser diode 14. The laser diode drive circuit 13 also adjust a DC bias current flowing through the laser diode 14 in response to an output signal of the APC circuit 15 applied to the input $IN_2$. In addition, the amplitude circuit 12 may have an AGC (Automatic Gain Control) function to make an optimum adjustment of the output level of the high frequency superposed signal. As described above, by applying the multivibrator circuit to the high frequency superposed circuit shown in Fig. 8, the following advantages are brought about.

(1) A high frequency signal which is necessary to reduce the light induced noise due to return light of a laser diode can be readily obtained.

(2) A monolithic integration can be easily attained because a circuit can be formed using the same kind of compound semiconductors as that of laser diodes, e.g. GaAs field effect transistors.

(3) By employing a source-coupled type circuit, it is made easy to connect the same type, that is, source-coupled type amplitude circuit and laser diode drive circuit as shown in Fig. 9, for example.

(4) By employing a source-coupled type circuit, the circuit can be driven by a single power supply.

Although the present invention has been described and illustrated in detail, it is clearly to be understood that the same is by way of illustration and example only and is not to be taken by way of limitation, the scope of the present invention being limited only by the terms of the appended claims.

## Claims

1. A multivibrator circuit (fig. 6) comprising:

   first and second alternately operable transistors ($Q_1$, $Q_2$); first and second current sources ($Q_3$, $Q_4$) connected to each first and second transistor ($Q_1$,$Q_2$) respectively; first and second voltage drop clamp circuit means ($R_1$, $D_1$ and $R_2$, $D_2$), including respective first and second diode means ($D_1$, $D_2$), connected to each first and second transistor ($Q_1$, $Q_2$) respectively; and timing capacitance means ($C_1$) connected between a junction ($N_3$) of said first transistor ($Q_1$) with said first current source ($Q_3$) and a junction ($N_4$) of said second transistor ($Q_2$) with said second current source ($Q_4$) wherein said circuit is so configured to produce an oscillating signal the frequency $f_0$ of which is given by the expression:

   $f_0 = I/4C\phi_B$; where

   I is the current supplied from each current source, ($Q_3$,$Q_4$), C is the capacitance of said timing capacitance means ($C_1$), and $2\phi_B$ is the range of voltage change across said capacitance means ($C_1$), $\phi_B$ being the diodic drop voltage of each of said first and second diode means ($D_1$,$D_2$); which circuit is characterized in that:

   each said first and second current source ($Q_3$,$Q_4$) comprises a field effect transistor ($Q_3$,$Q_4$) and has a third diode means ($D_5$) connected between its gate electrode and its source electrode to effect a reduction in the temperature coefficient of the oscillation frequency $f_0$.

2. A multivibrator circuit as claimed in claim 1 wherein the gate electrodes of each of said field effect transistors ($Q_3$,$Q_4$) are connected together ($N_5$), the source electrodes of each of said field effect transistors are connected together ($V_{SS}$), and a common diode means ($D_5$) is provided as said third diode means.

3. A multivibrator circuit as claimed in either one of the preceding claims wherein the gate electrode of each of said field effect transistors ($Q_3$,$Q_4$) is connectable to a source of bias voltage ($V_{cs1}$) via a coupling resistance means ($R_3$) provided therefor.

4. A multivibrator circuit as claimed in any one of the preceding claims wherein said first and second alternately operable transistors ($Q_1$,$Q_2$) also are field effect transistors.

5. A multivibrator circuit as claimed in claim 3 or 4 further comprising:

   a first power supply rail ("$V_{DD1}$") connected to said first and second voltage drop clamp circuit means ($R_1$, $D_1$ & $R_2$,$D_2$);

   first and second drive transistors ($Q_5$, $Q_6$) each of field effect transistor type and having a gate electrode connected to said first and second voltage drop clamp circuit means ($R_1$, $D_1$ & $R_2$, $D_2$)

respectively;

first and second level-shifting means ($D_3$,$D_4$), connected to the source electrode of each of said first and second drive transistors ($Q_5$,$Q_6$) respectively, and cross-coupled at their opposite extremity ($N_1$,$N_2$) to the gate electrode of each of said second and first alternately operable transistors ($Q_2$, $Q_1$) respectively so that the latter are each operable in saturation; and;

third and fourth current supply means ($Q_7$,$Q_8$) connected to said first and second level-shifting means ($D_3$,$D_4$).

**6.** A multivibrator circuit, as claimed in claim 5, comprising a second power supply rail ("$V_{DD2}$") connected to the drain electrode of each of said first and second drive transistors ($Q_5$,$Q_6$).

**7.** A multivibrator circuit, as claimed in claim 6, wherein said first and second power supply rails ("$V_{DD1}$", "$V_{DD2}$") are connected to lower and higher voltage power supply sources ($V_{DD1}$, $V_{DD2}$) respectively whereby said first and second drive transistors ($Q_5$, $Q_6$) also are each operable in saturation.

**8.** A multivibrator circuit, as claimed in any one of the preceding claims wherein each field effect transistor is of gallium arsenide metal-semiconductor (GaAs MESFET) type.

**Revendications**

**1.** Un circuit multivibrateur (figure 6) comprenant : des premier et second transistors ($Q_1$, $Q_2$) que l'on peut activer en alternance ; des première et seconde sources de courant ($Q_3$, $Q_4$) connectées respectivement à chacun des premier et second transistors ($Q_1$, $Q_2$) ; des premier et second circuits de fixation de chute de tension ($R_1$, $D_1$ et $R_2$, $D_2$), comprenant des premiers et seconds moyens à diodes respectifs ($D_1$, $D_2$), connectés respectivement à chacun des premier et second transistors ($Q_1$, $Q_2$) ; et des moyens de temporisation capacitifs ($C_1$) connectés entre un point de connexion ($N_3$) du premier transistor ($Q_1$) et de la première source de courant ($Q_3$), et un point de connexion ($N_4$) du second transistor ($Q_2$) et de la seconde source de courant ($Q_4$), ce circuit ayant une configuration telle qu'il produit un signal d'oscillation dont la fréquence $f_0$ est donnée par l'expression $f_0 = I/4C\phi_B$, dans laquelle I est le courant fourni par chaque source de courant ($Q_3$, $Q_4$), C est la capacité des moyens de temporisation capacitifs ($C_1$), et $2\phi_B$ est la plage de changement de tension aux bornes des moyens capacitifs ($C_1$), $\phi_B$ étant la chute de tension de diode de chacun des premiers et seconds moyens à diodes ($D_1$, $D_2$), ce circuit étant caractérisé en ce que :

chacune des première et seconde sources de courant ($Q_3$, $Q_4$) comprend un transistor à effet de champ ($Q_3$, $Q_4$), et elle comporte des troisièmes moyens à diodes ($D_5$) connectés entre son électrode de grille et son électrode de source, pour réduire le coefficient de température de la fréquence d'oscillation $f_0$.

**2.** Un circuit multivibrateur selon la revendication 1, dans lequel les électrodes de grille de chacun des transistors à effet de champ ($Q_3$, $Q_4$) sont connectées ensemble ($N_5$), les électrodes de source de chacun des transistors à effet de champ sont connectées ensemble ($V_{SS}$), et des moyens à diodes communs ($D_5$) sont incorporés pour les troisièmes moyens à diodes.

**3.** Un circuit multivibrateur selon l'une quelconque des revendications précédentes, dans lequel l'électrode de grille de chacun des transistors à effet de champ ($Q_3$, $Q_4$) peut être connectée à une source de tension de polarisation ($V_{cs1}$) par l'intermédiaire de moyens de couplage résistifs ($R_3$) qui sont incorporés dans ce but.

**4.** Un circuit multivibrateur selon l'une quelconque des revendications précédentes, dans lequel les premier et second transistors ($Q_1$, $Q_2$) pouvant être activés en alternance, sont également des transistors à effet de champ.

**5.** Un circuit multivibrateur selon la revendication 3 ou 4, comprenant en outre :

une première ligne d'alimentation ("$V_{DD1}$") qui est connectée aux premier et second circuits de fixation de chute de tension ($R_1$, $D_1$ et $R_2$, $D_2$) ;

des premier et second transistors d'attaque ($Q_5$, $Q_6$), chacun d'eux étant du type à effet de champ, et ayant une électrode de grille connectée respectivement aux premier et second circuits de fixation de chute de tension ($R_1$, $D_1$ et $R_2$, $D_2$) ;

des premiers et seconds moyens de décalage de niveau ($D_3$, $D_4$) qui sont respectivement connectés à l'électrode de source de chacun des premier et second transistors d'attaque ($Q_5$, $Q_6$), et dont les extrémités opposées ($N_1$, $N_2$) sont connectées de façon croisée à l'électrode de grille respective de chacun des second et premier transistors ($Q_2$, $Q_1$) pouvant être activés en alternance, de façon que chacun de ces derniers puisse fonctionner en saturation ; et
des troisième et quatrième sources de courant ($Q_7$, $Q_8$) connectées aux premiers et seconds moyens de décalage de niveau ($D_3$, $D_4$).

6. Un circuit multivibrateur selon la revendication 5, comprenant une seconde ligne d'alimentation ("$V_{DD2}$") connectée à l'électrode de drain de chacun des premier et second transistors d'attaque ($Q_5$, $Q_6$).

7. Un circuit multivibrateur selon la revendication 6, dans lequel les première et seconde lignes d'alimentation ("$V_{DD1}$", "$V_{DD2}$") sont respectivement connectées à des sources d'alimentation de tension inférieure et supérieure ($V_{DD1}$, $V_{DD2}$), grâce à quoi chacun des premier et second transistors d'attaque ($Q_5$, $Q_6$) peut également fonctionner en saturation.

8. Un circuit multivibrateur selon l'une quelconque des revendications précédentes, dans lequel chaque transistor à effet de champ est du type métal-semiconducteur à l'arséniure de gallium (MESFET au GaAs).

## Patentansprüche

1. Multivibratorschaltung (Fig. 6) mit:
einem ersten und zweiten abwechselnd betreibbaren Transistor ($Q_1$, $Q_2$); einer mit jeweils dem ersten und zweiten Transistor ($Q_1$, $Q_2$) verbundenen Stromquelle ($Q_3$, $Q_4$); einem ersten und zweiten Spannungsabfallklemmschaltungsmittel ($R_1$, $D_1$ und $R_2$, $D_2$) mit einem entsprechenden ersten und zweiten Diodenmittel ($D_1$, $D_2$), die jeweils mit dem entsprechenden ersten und zweiten Transistor ($Q_1$, $Q_2$) verbunden sind; einem Zeitkondensatormittel ($C_1$), das zwischen einer Verbindung ($N_3$) des ersten Transistors ($Q_1$) mit der ersten Stromquelle ($Q_3$) und einer Verbindung ($N_4$) des zweiten Transistors ($Q_2$) mit der zweiten Stromquelle ($Q_4$) geschaltet ist, wobei die Schaltung so ausgelegt ist, daß sie ein oszillierendes Signal der Frequenz $f_0$, die durch den Ausdruck

$$f_0 = I/4C\phi_B$$

gegeben ist, erzeugt; wobei I der von jeder Stromquelle ($Q_3$, $Q_4$) zugeführte Strom ist, C die Kapazität des Zeitkondensatormittels ist und $2\phi_B$ der Bereich der Spannungsänderung über das Kondensatormittel ($C_1$) ist, wobei $\phi_B$ der diodische Spannungsabfall über jedes des ersten und zweiten Diodenmittels ($D_1$, $D_2$) ist; wobei die Schaltung dadurch gekennzeichnet ist,
daß jede der ersten und zweiten Stromquelle ($Q_3$, $Q_4$) einen Feldeffekttransistor ($Q_3$, $Q_4$) aufweist und ein drittes Diodenmittel ($D_5$) zwischen seiner Gateelektrode und seiner Sourceelektrode zum Bewirken einer Reduktion des Temperaturkoeffizienten der Oszillationsfrequenz $f_0$ geschaltet aufweist.

2. Multivibratorschaltung nach Anspruch 1, bei der die Gateelektroden eines jeden der Feldeffekttransistoren ($Q_3$, $Q_4$) zusammengeschaltet ($N_5$) sind, die Sourceelektroden von jedem der Feldeffekttransistoren zusammengeschaltet ($V_{SS}$) sind und ein gemeinsames Diodenmittel ($D_5$) als das dritte Diodenmittel vorgesehen ist.

3. Multivibratorschaltung nach einem der vorhergehenden Ansprüche, bei dem die Gateelektrode von jedem der Feldeffekttransistoren ($Q_3$, $Q_4$) mit einer Quelle einer Vorspannung ($V_{cs1}$) über ein Koppelwiderstandsmittel ($R_3$) verbindbar ist, das dafür vorgesehen ist.

4. Multivibratorschaltung nach einem der vorhergehenden Ansprüche, bei dem der erste und zweite abwechselbar betreibbare Transistor ($Q_1$, $Q_2$) ebenfalls ein Feldeffekttransistor ist.

5. Multivibratorschaltung nach Anspruch 3 oder 4, weiter mit:
einer ersten Versorgungsspannungsschiene ("$V_{DD1}$"), die mit dem ersten und zweiten Spannungsabfallklemmschaltungsmittel ($R_1$, $D_1$ und $R_2$, $D_2$) verbunden ist;
einem ersten und zweiten Treibertransistor ($Q_5$, $Q_6$), die jeweils von dem Feldeffekttransistortyp sind und eine mit dem ersten bzw. zweiten Spannungsabfallklemmschaltungsmittel ($R_1$ $D_1$ und $R_2$, $D_2$) verbundene Gateelektrode aufweisen;

einem ersten und zweiten Pegelverschiebungsmittel ($D_3$, $D_4$), das mit der Sourceelektrode eines jeden des ersten bzw. zweiten Treibertransistors ($Q_5$, $Q_6$) verbunden ist und über Kreuz an seinem entgegengesetzten Ende ($N_1$, $N_2$) mit der Gateelektrode eines jeden des zweiten bzw. ersten abwechselnd betreibbaren Transistors ($Q_2$, $Q_1$) verbunden ist, so daß der letztere jeweils in der Sättigung betrieben werden kann; und

einem dritten und vierten Stromversorgungsmittel ($Q_7$, $Q_8$), das mit dem ersten und zweiten Pegelverschiebungsmittel ($D_3$, $D_4$) verbunden ist.

6. Multivibratorschaltung nach Anspruch 5, mit einer zweiten Spannungsversorgungsschiene ("$V_{DD2}$"), die mit der Drainelektrode eines jeden des ersten und zweiten Treibertransistors ($Q_5$, $Q_6$) verbunden ist.

7. Multivibratorschaltung nach Anspruch 6, bei der die erste und zweite Spannungsversorgungsschiene ("$V_{DD1}$", "$V_{DD2}$") mit der niedrigeren bzw. höheren Spannungsversorgungsquelle ($V_{DD1}$, $V_{DD2}$) verbunden sind, wobei der erste und zweite Treibertransistor ($Q_5$, $Q_6$) ebenfalls in der Sättigung betreibbar sind.

8. Multivibratorschaltung nach einem der vorhergehenden Ansprüche, bei der jeder Feldeffekttransistor vom Galliumarsenid-Metallhalbleiter-(GaAsMESFET)-Typ ist.

FIG.1

FIG.3

# FIG.2

# FIG.4

$I_D$

I NON-SATURATION REGION

II SATURATION REGION

$I_D = K V_D^2$

$K(V_G - V_{th})^2$

$I_D = K\{2(V_G - V_{th})V_D - V_D^2\}$

$V_G - V_{th}$

$V_D$

# FIG.6

# FIG.5

# FIG.8

```
┌─────────────┐      ┌─────────────┐      ┌─────────────┐      14
│             │  11  │             │  12  │             │  13   ▽
│ MULTIVIBRATOR│      │  AMPLITUDE  │      │ LASER DIODE │
│   CIRCUIT   │──────│   CIRCUIT   │──────│DRIVE CIRCUIT│
└─────────────┘      └─────────────┘      └──────┬──────┘
                                                  │
                                          ┌───────┴─────┐  15
                                          │   A P C     │
                                          │   CIRCUIT   │
                                          └─────────────┘
```

FIG.9